(19) Europäisches Patentamt
European Patent Office
Office européen des brevets

(11) **EP 2 754 167 B1**

(12) **EUROPÄISCHE PATENTSCHRIFT**

(45) Veröffentlichungstag und Bekanntmachung des Hinweises auf die Patenterteilung:
**10.10.2018   Patentblatt 2018/41**

(21) Anmeldenummer: **12769011.3**

(22) Anmeldetag: **29.08.2012**

(51) Int Cl.:
***H01J 37/32*** *(2006.01)*

(86) Internationale Anmeldenummer:
**PCT/EP2012/003623**

(87) Internationale Veröffentlichungsnummer:
**WO 2013/034258 (14.03.2013 Gazette 2013/11)**

(54) **PLASMAQUELLE**

PLASMASOURCE

SOURCE PLASMA

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.09.2011   DE 102011112759**

(43) Veröffentlichungstag der Anmeldung:
**16.07.2014   Patentblatt 2014/29**

(73) Patentinhaber: **Oerlikon Surface Solutions AG, Pfäffikon**
**8808 Pfäffikon (CH)**

(72) Erfinder:
• **KRASSNITZER, Siegfried**
**A-6800 Feldkirch (AT)**

• **LENDI, Daniel**
**CH-9472 Grabs (CH)**
• **HAGMANN, Juerg**
**CH-9468 Sax (CH)**

(74) Vertreter: **Kempkens, Anke**
**Hofgraben 486**
**86899 Landsberg (DE)**

(56) Entgegenhaltungen:
**GB-A- 2 267 387        GB-A- 2 395 286**
**JP-A- 5 074 395        US-A1- 2002 056 814**
**US-A1- 2006 151 786        US-A1- 2009 309 509**

## Beschreibung

Die vorliegende Erfindung betrifft eine Plasmaquelle gemäss dem Oberbegriff des Anspruchs 1. Die Erfindung betrifft ausserdem ein Verfahren zur Erzeugung eines Plasmas mittels einer thermionischen Entladung.

Dabei wird ein Filament mittels Strom beheizt, was zur Emission von Elektronen aus der heissen Oberfläche des Filamentes führt. Die Emission von Elektronen aus heissen Oberflächen folgt dem von Richardson erstmals beschriebenen Gesetz:

$$J = A_G T^2 e^{-W/kT},$$

wobei J die Stromdichte, T die Temperatur und W die Austrittsarbeit der Elektronen ist.

Erreicht die Oberfläche des Filamentes eine Temperatur welche für Wolfram grösser als ca. 2900 K ist, werden ausreichend Elektronen aus der Oberfläche emittiert, so dass mit deren Hilfe sobald sie aufgrund einer Spannung genügend beschleunigt sind, Argongas in solchem Umfang ionisiert werden kann dass ein Plasma aufrecht erhalten bleibt.

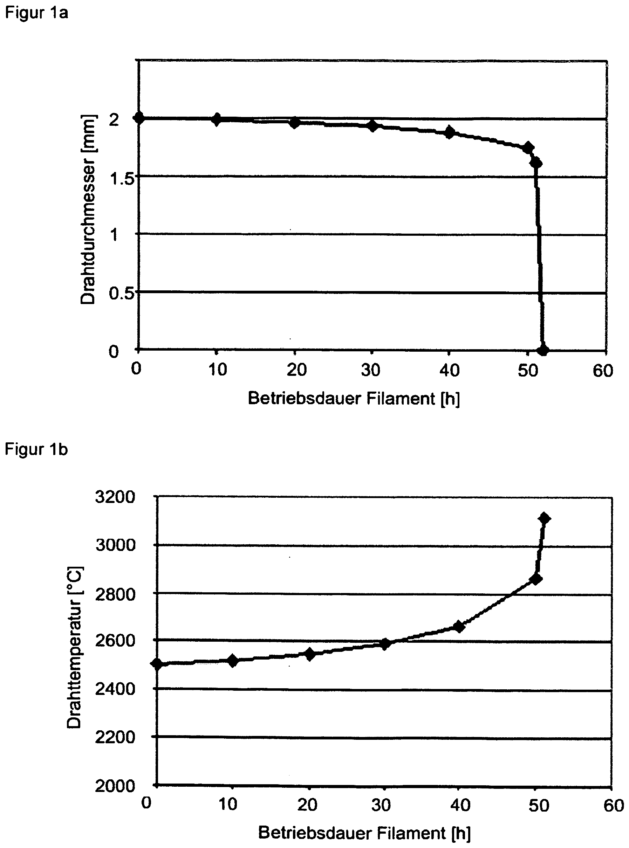

Gemäss Stand der Technik wird die Heizung des Filaments über eine konstante Stromstärke durchgeführt. Bei angelegter Wechselspannung wird meist über eine Phasenschnittsteuerung der Effektivwert des Stromes geregelt. Bei Betrieb unter hohen Temperaturen verdampft das Filamentmaterial (z.B. Tungsten) wodurch sich der Drahtdurchmesser des Filamentes reduziert. In der Folge steigt der durch den Draht definierte Widerstand des Filamentes. Bei gleichbleibendem Heizstrom führt dies zu einer stärkeren Erhitzung und damit zu einer beschleunigten Verdampfung des Filamentmaterials. Es kommt innerhalb kurzer Zeit zu einem Durchschmelzen. Figur 1a zeigt den Durchmesser des Filamentes in Abhängigkeit von der Betriebsdauer bei gleichbleibendem Heizstrom. Entsprechend zeigt Figur 1b die Filamenttemperatur in Abhängigkeit von der Betriebsdauer bei gleichbleibendem Heizstrom. Dabei ist deutlich zu sehen dass es nach einer anfänglich konstanten Abnahme des Drahtdurchmessers zu einem schnellen Durchbrennen des Filamentes (pinch through effect) kommt. Beispiele von Plasmaquellen gemäß dem Stand der Technik sind in GB 2 267 387 A und JP 5 074395 A offenbart.

Der vorliegenden Erfindung liegt die Aufgabe zugrunde ein Verfahren und eine Plasmaquelle anzugeben, mit dem ein solches schnelles Durchbrennen zu vermieden werden kann und damit die Betriebsdauer, d.h. die Filamentstandzeit, erhöht werden kann.

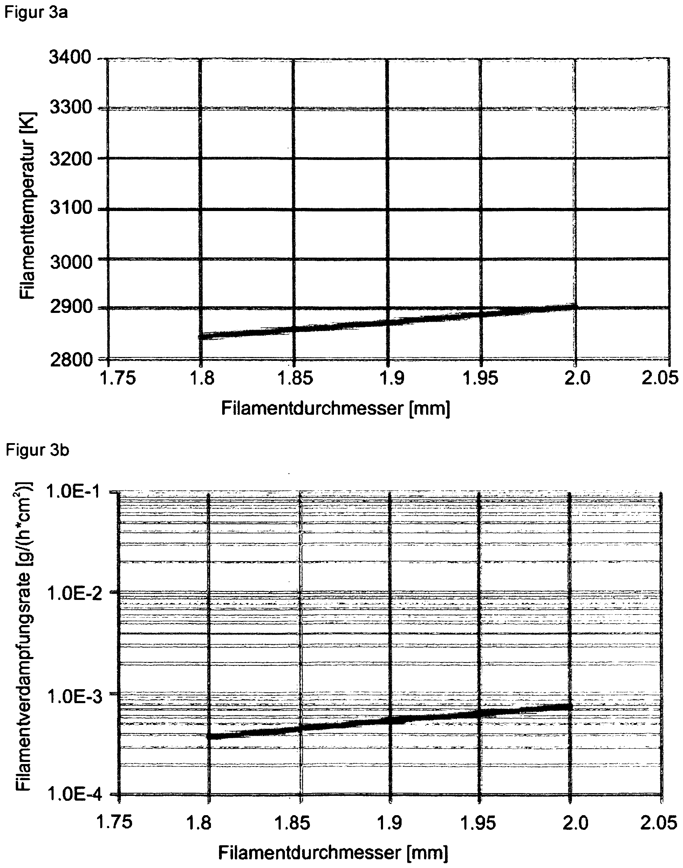

Bei ihren Versuchen zur Erhöhung der Standzeit haben die Erfinder einerseits festgestellt, dass bei konstant gehaltener Temperatur des Filamentdrahtes sich der Drahtdurchmesser mit nahezu konstanter Rate verringert. Figur 3 zeigt die Entwicklung des Drahtdurchmessers in Abhängigkeit der Betriebsdauer des Filamentes, mit konstanter Temperatur und zum Vergleich eine Messung mit bei konstanter Stromstärke.

Bei ihren Versuchen haben die Erfinder andererseits überraschender Weise festgestellt, dass bei einem Betrieb mit konstantem Spannungsabfall zwischen Filament und Plasma die Temperatur des Filamentes nahezu konstant bleibt und die Verdampfungsrate mit abnehmendem Filamentdurchmesser sogar abnimmt. Erfindungsgemäss wird daher das Filament nicht mit konstanter Stromstärke sondern mit konstanter Spannung betrieben.

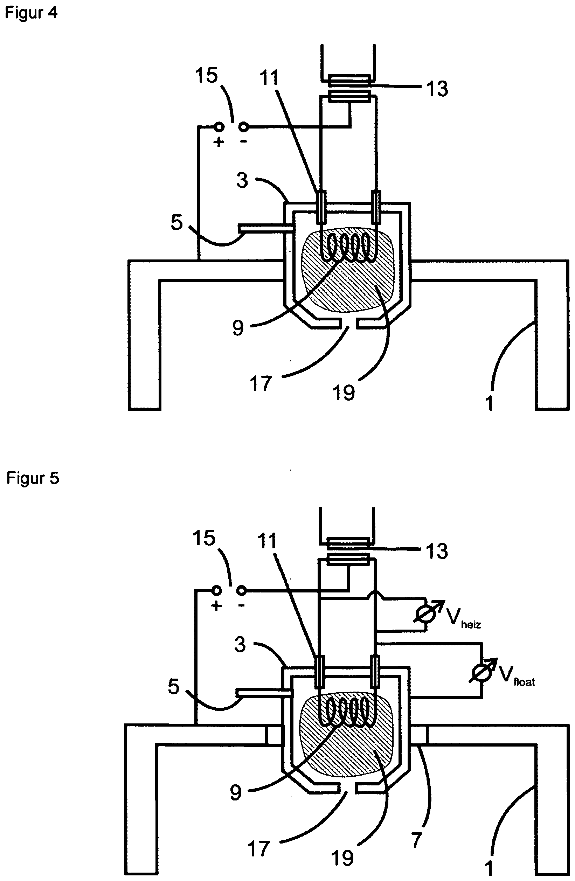

Die Erfindung wird nun im Detail und anhand der Figuren beispielhaft beschrieben. Figur 4 zeigt ein Plasmaquelle gemäss dem Stand der Technik welches an einer Vakuumkammer 1 angeordnet ist. Die Plasmaquelle umfasst ein Quellengehäuse 3 mit einem Einlass 5 für Argongas. Im Quellengehäuse 3 ist ein Filament 9 vorgesehen welches über vom Quellengehäuse 3 isolierte Durchlässe 11 an einen Transformator 13 angeschlossen ist. Das Filament 9 besteht im Beispiel aus einem Wolframdraht mit 2mm Durchmesser. Der Transformator wird im Beispiel mit einer Wechselspannung mit 50Hz betrieben. Durch das Filament 9 fliesst ein Heizstrom von ca. 200A. Erreicht die Oberfläche des Filamentes 9 eine Temperatur grösser 2900 K werden ausreichend Elektronen aus der Filamentoberfläche emittiert welche unter Anlegung einer Entladespannung mittels Spannungsquelle 15 zwischen der Vakuumkammer 15 und dem Transformator 13 das über den Einlass 5 in das Innere des Quellengehäuses 3 strömende Argongas ionisieren kann. Die Zündung der Entladung erfolgt im ersten Moment über einen Widerstand welcher das Quellengehäuse 3 mit der Masse verbindet (nicht gezeigt). Sind ausreichend Ladungsträger vorhanden, so kann der Entladestrom durch die Öffnung 17 (auch "orifice" genannt) in die Vakuumkammer 1 geführt werden.

Erfindungsgemäss wird nun, wie in Figur 5 dargestellt das Quellengehäuse mittels Isolierung 7 elektrisch isoliert an der Vakuumkammer 1 angeordnet und es wird die Spannung zwischen dem auf schwebendem Potential gehaltenen Quellengehäuse 3 und der Zuführungsleitung zum Filament 9 gemessen. Das Filament 9 wird durch einen Strom I aufgeheizt. Am Filament fällt eine Spannung $V_{heiz}$ ab, welche über den Transformator 13 eingestellt werden kann. Nachdem der Quellenkörper 3 elektrisch schwebend (floatend) montiert ist, kann die erfindungsgemässe Potentialmessung zwischen der als Kathode bezeichneten Zuführungsleitung und dem Quellengehäuse als Charakteristik für den Zustand des Potentialabfalls zwischen Filament 9 und im Innern des Quellengehäuses gezündeten Plasma 19, und damit für den Zustand des Austritts von Elektronen aus dem Filament gewertet werden. Erfindungsgemäss wird dieser Zustand im Wesentlichen konstant gehalten, beispielsweise durch Regelung der Heizspannung $U_{heiz}$. Die Messung von $V_{float}$ ermöglicht also die Beibehaltung des optimalen Zustandes für den Elektronenaustritt beizubehalten. Auf diese Weise kann die Temperatur des Filamentes optimal gehalten werden. Optimal heisst in diesem Zusammenhang, dass bei dieser Temperatur der Verdampfungsrate des Filamentmaterials akzeptabel klein ist, jedoch gross genug um eine für die Aufrechterhaltung des Plasmas genügend hohe Elektronenemission zu gewährleisten. Somit wird die Lebensdauer des Filamentes, d.h. die Standzeit wesentlich gegenüber dem Stand der Technik erhöht werden.

Gemäss einer Ausführungsform der vorliegenden Erfindung können Plasmaquellenanordnungen zum Heizen und Plasmaätzen von Substraten eine Vielzahl von Plasmaquellen umfassen die nach dem Prinzip der thermionischen Emission funktionieren. Die Filamente der Plasmaquellen werden über angelegte Spannungen beheizt, wobei erfindungsgemäss die angelegten Spannungen derart geregelt werden, das die Spannung zwischen Filament und floatendem Quellengehäuse einen vorzugsweise im Wesentlichen konstanten Wert zwischen 0V und -10V erreicht. Vorzugsweise erfolgt die Beheizung über ein Schaltnetzteil. An den einzelnen Plasmaquellen sind gemäss dieser Ausführungsform Quellenspulen vorgesehen. Das Plasma in der Behandlungskammer wird über die Kombination des Magnetfeldes einer äusseren Spule und der Magnetfelder der Quellenspulen über die Behandlungshöhe verteilt. Als Entladungsanode kann die Behandlungskammer und/oder eine floatend isoliert durchgeführte Anode dienen.

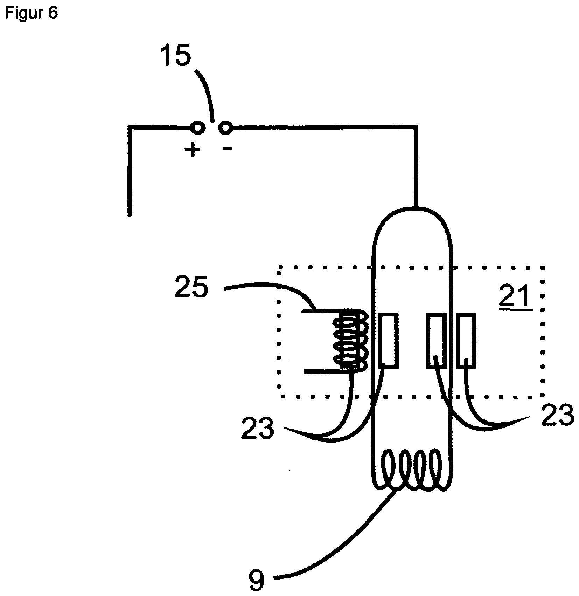

Gemäss einer weiteren Ausführungsform der vorliegenden Erfindung wird der Transformator 13 durch ein sogenanntes Schaltnetzteil 21 ersetzt, wie in Figur 6 dargestellt. Ein solches Schaltnetzteil 21 umfasst einen Ferritkern 23, um den Wicklungen einer Primärspule 25 gewickelt sind (nur für einen Teil des Ferritkerns gezeigt), während die Zuleitungen zum Filament beispielsweise lediglich eine Schlaufe bilden. Erfindungsgemäss ist an beiden Zuleitungen zum Filament ein Ferritkern vorgesehen und die Entladungsspannung $V_{Disc}$ wird zentral an der dem Filament 9 gegenüberliegenden Seite angelegt. Auf diese Weise, d.h. mit Hilfe des Schaltnetzteiles wird eine sehr kleine und kompakte Plasmaquelle realisiert

## Patentansprüche

1. Plasmaquelle an einer Vakuumkammer (1) zum Erzeugen eines Plasmas (19) in der Vakuumkammer (1) wobei die Plasmaquelle ein Quellengehäuse (3) mit in die Vakuumkammer (1) hineinragender Öffnung (17) umfasst und in dem Quellengehäuse (3) ein Filament (9) vorgesehen ist an welches über isoliert durch das Quellengehäuse (3) durchgeführte elektrische Leitungen eine Heizspannung ($V_{heiz}$) angelegt werden kann so dass das Filament (9) mittels Stromfluss aufgeheizt werden kann, wobei das Quellengehäuse (3) elektrisch isoliert von der Vakuumkammer (1) an dieser angeordnet ist, **dadurch gekennzeichnet, dass**:

   • Mittel vorgesehen sind welche es erlauben den Spannungsabfall $U_{float}$ zwischen der Zuführungsleitung zum Filament (9) und dem Quellengehäuse (3) als Charakteristik für den Zustand des Potentialabfalls zwischen Filament (9) und im Innern des Quellengehäuses (3) gezündeten Plasma (19) zu messen und
   • Mittel zur Regelung der Heizspannung ($V_{heiz}$) vorgesehen sind welche so ausgestaltet sind dass sie als Regelsignal den gemessenen Wert $U_{float}$ verarbeiten können, dergestalt dass der Spannungsabfall $U_{float}$ konstant gehalten werden kann und dadurch die Temperatur des Filaments (9) nahezu konstant gehalten werden kann.

2. Vorrichtung mit einer Vielzahl von Plasmaquellen nach Anspruch 1, **dadurch gekennzeichnet, dass** die Plasmaquellen von jeweils zumindest einer Quellenspule umgeben sind und die Plasmaquellen von einer sich erstreckenden, mehrere Plasmaquellen umfassenden äusseren Spule umgeben sind, dergestalt dass das Plasma in der Behandlungskammer über die Behandlungshöhe verteilt werden kann.

3. Vorrichtung nach Anspruch 1 oder 2, **dadurch gekennzeichnet, dass** die Heizspannung mittels zumindest eines Schaltnetzteils gespeist wird, welches vorzugsweise einen Ferritkern (23) umfasst, um den Wicklungen einer Primärspule (25) gewickelt sind, wobei vorzugsweise eine für die Entladung notwendige Entladungsspannung $U_{disc}$ zentral hinsichtlich des Filaments und der dem Filament gegenüberliegenden Seite angelegt wird.

4. Verfahren zum Erzeugen eines Plasmas in einer Vakuumkammer, wobei an die Vakuumkammer eine Plasmaquelle gemäß Anspruch 1 angeordnet ist und zur Aufrechterhaltung des Plasmas das Quellengehäuse gegenüber der Vakuumkammer und dem Filament auf schwebendem elektrischen Potential, d. h. floatend gehalten wird und wobei zur Aufrechterhaltung des Plasmas der Potentialabfall zwischen Filament und Quellengehäuse in dessen Inneren ein Plasma brennt gemessen wird und der gemessene Potentialabfall zur Regelung einer an das Filament angelegten Heizspannung verwendet wird wobei die Heizspannung einen das Filament erhitzenden Strom und damit eine Elektronenemission zur Folge hat.

5. Verfahren nach Anspruch 3, **dadurch gekennzeichnet, dass** die Heizspannung so geregelt wird dass der Potentialabfall zwischen Quellengehäuse und Filament im Wesentlichen konstant gehalten wird.

6. Verfahren nach einem der Anspruche 3 und 4, **dadurch gekennzeichnet, dass** der Potentialabfall zwischen Quellengehäuse und Filament auf Werten zwischen 0 V und -10 V gehalten wird.

**Claims**

1. Plasma source on a vacuum chamber (1) for generating a plasma (19) in the vacuum chamber (1), wherein the plasma source comprises a source housing (3) with an opening (17) protruding into the vacuum chamber (1) and in the source housing (3) a filament (9) is provided to which a heater voltage ($V_{heiz}$) can be applied through electric lines running insulated through the source housing (3), so that the filament (9) can be heated by means of the current flow, wherein the source housing (3) is placed on the vacuum chamber (1) in a manner electrically insulated therefrom, **characterized in that**:

   • means are provided which allow to measure the potential drop $U_{float}$ between the supply line to the filament (9) and the source housing (3) as characteristic for the state of the potential drop between the filament (9) and a plasma (19) ignited inside the source housing (3) and
   • means are provided for regulating the heater voltage ($V_{heiz}$) that are designed in such a manner that they can process the measured value $U_{float}$ as control signal in such a manner that the voltage drop $U_{float}$ can be maintained constantly and thus the temperature of the filament (9) can be maintained almost constantly.

2. Device with a plurality of plasma sources according to claim 1, **characterized in that** the plasma sources are surrounded respectively by at least one source coil and the plasma sources are surrounded by an outer coil comprising several plasma sources in such a manner that the plasma can be distributed in the processing chamber over the processing height.

3. Device according to claim 1 or 2, **characterized in that** the heater voltage is fed by means of at least one switched-mode power supply which comprises preferably a ferrite core (23) around which windings of a primary coil (25) are wound, wherein preferably a discharge voltage $U_{disc}$ required for the discharge is applied centrally with respect to the filament on the side opposite the filament.

4. Method for generating a plasma in a vacuum chamber, wherein a plasma source according to claim 1 is placed on the vacuum chamber and, in order to maintain the plasma, the source housing is maintained opposite the vacuum chamber and the filament on a floating electric potential, i.e. in a floating manner, and wherein, in order to maintain the plasma, the potential drop between the filament and the source housing inside which a plasma is burning is measured and the measured potential drop is used for regulating a heater voltage applied to the filament, wherein the heater voltage results in a current heating the filament and thus in an emission of electrons.

5. Method according to claim 3, **characterized in that** the heater voltage is regulated in such a manner that the potential drop between the source housing and the filament is essentially maintained constant.

6. Method according to one of the claims 3 and 4, **characterized in that** the potential drop between the source housing and the filament is maintained at values between 0V and -10V.

**Revendications**

1. Source de plasma à une chambre à vide (1) pour générer un plasma (19) dans la chambre à vide (1), la source de plasma comprenant un boîtier de source (3) ayant un orifice (17) qui avance dans la chambre à vide (1) et dans le boîtier de source (3) un filament (9) est prévu auquel une tension de chauffage ($V_{heiz}$) peut être appliquée par l'intermédiaire de fils électriques guidés de façon isolée au travers du boîtier de source (3) de telle manière que le filament (9) peut être chauffé au moyen de courant, le boîtier de source (3) étant disposé à la chambre à vide (1) de façon électriquement isolée de celle-ci, **caractérisé en ce que** :

   • des moyens sont prévus qui permettent de mesurer la chute de tension $U_{float}$ entre la conduite amenant au filament (9) et le boîtier de source (3) comme caractéristique de l'état de la chute de potentiel entre le filament (9) et le plasma (19) allumé à l'intérieur du boîtier de source (3) et
   • des moyens sont prévus à réguler la tension de chauffage ($V_{heiz}$), quels moyens sont désignés de telle manière qu'ils peuvent traiter comme signal régulateur la valeur mesurée $U_{float}$ de telle manière que la chute de tension $U_{float}$ peut être maintenue constante et ainsi la température du filament (9) peut être maintenue presque constante.

2. Dispositif ayant une pluralité de sources de plasma selon la revendication 1, **caractérisé en ce que** les sources de plasma sont entourées chacune d'au moins une bobine de source et les sources de plasma sont entourées d'une bobine extérieure comprenant plusieurs sources de plasma de telle manière que le plasma peut être distribué dans la chambre de traitement sur la hauteur de traitement.

3. Dispositif selon l'une des revendications 1 ou 2, **caractérisé en ce que** la tension de chauffage est alimentée au moyen d'au moins une alimentation de commutation qui comprend de préférence un noyau de ferrite (23) autour duquel des enroulements d'une bobine primaire (25) sont enroulés, de préférence une tension de décharge $U_{disc}$ nécessaire à la décharge étant appliquée centralement par rapport au filament et sur le côté opposé au filament.

4. Procédure pour générer un plasma dans une chambre à vide, une source de plasma selon la revendication 1 étant disposée à la chambre à vide et, pour maintenir le plasma, le boîtier de source opposé à la chambre à vide et au filament est maintenu à un potentiel électrique flottant, c'est-à-dire de façon flottante, et pour maintenir le plasma la chute de potentiel entre le filament et le boîtier de source, à l'intérieur duquel un plasma brûle, étant mesurée et la chute de potentiel mesurée étant utilisée pour régler une tension de chauffage appliquée au filament, la tension de chauffage entraînant un courant chauffant le filament et ainsi une émission d'électrons.

5. Procédure selon la revendication 3 **caractérisée en ce que** la tension de chauffage est réglée de telle manière que la chute de potentiel entre le boîtier de source et le filament est maintenue essentiellement constante.

6. Procédure selon l'une des revendications 3 et 4 **caractérisée en ce que** la chute de potentiel entre le boîtier de source et le filament est maintenue à des valeurs entre 0V et -10V.

Figur 1a

Figur 1b

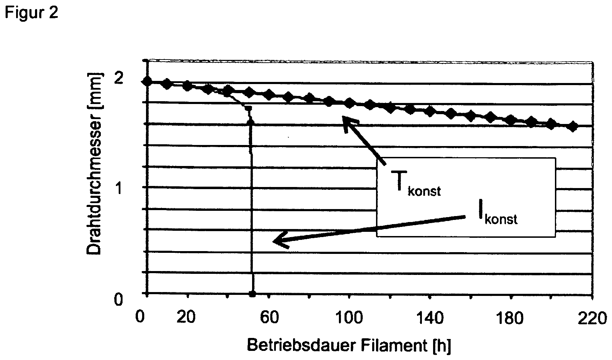

Figur 2

Figur 3a

Figur 3b

Figur 4

15  11
13

3
5

9

17  19  1

Figur 5

15  11
13

$V_{heiz}$

3
$V_{float}$
5

9

17  19  7  1

Figur 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2267387 A

- JP 5074395 A